# EUROPÄISCHE PATENTANMELDUNG

(11) **EP 2 000 736 A1**
(43) Veröffentlichungstag der Anmeldung: **10.12.2008**
(21) Anmeldenummer: 07405161.6
(22) Anmeldetag: 05.06.2007
(51) Int. Cl.: F21K 7/00, H05K 1/05

(54) **Flächige Beleuchtungseinrichtung**

(71) Anmelder: Alcan Technology & Management Ltd., 8212 Neuhausen am Rheinfall (CH)
(72) Erfinder: Layer, Hans, 89075 Ulm (DE); Jannon, Bertrand, 78343 Horn (DE)

(57) **Zusammenfassung**

Flächige Beleuchtungseinrichtung mit auf einem Träger, enthaltend eine elektrisch isolierende Schicht (14) und eine elektrisch leitende Schicht (15), angeordneten Licht emittierenden Beleuchtungselementen (5), sog. LEDs. Die Licht emittierenden Beleuchtungselemente sind zu deren Stromversorgung mit Stromzuleitungen in Form einer Leiterbahn (3) verbunden. Die Leiterbahn ist beispielsweise eine auf die elektrisch isolierende Schicht aufgedruckte Leiterbahn. Die Licht emittierenden Beleuchtungselemente sind als Abfolge gleicher Einheiten auf einer fortlaufenden Trägerbahn, jeweils auf der elektrisch isolierenden Schicht des Trägers, angeordnet. Von den Licht emittierenden Beleuchtungselementen wird durch einen den Strom abführenden Leiter und mittels einer Verbindung zur elektrisch leitenden Schicht (15) des Trägers die Stromableitung dargestellt. Die flächige Beleuchtungseinrichtung besteht aus einer beliebigen Anzahl sich in Längs- und Querrichtung erstreckenden Einheiten. Zwischen den Einheiten befinden sich Schneidezonen, entlang derer beliebig Einheiten oder Gruppen von Einheiten abgetrennt oder herausgetrennt werden können.

## Beschreibung

Vorliegende Erfindung betrifft eine flächige Beleuchtungseinrichtung mit auf einem Träger, enthaltend eine elektrisch leitende und eine isolierende Schicht, angeordneten Licht emittierenden Beleuchtungselementen, die zur Stromversorgung mit Stromzuleitungen in Form wenigstens einer Leiterbahn verbunden sind.

Es sind flächige Beleuchtungseinrichtungen aus der WO 2006/097225 bekannt. Darin sind, auf einem Träger angeordnet, Licht emittierende Beleuchtungselemente beschrieben. Eine metallische Folie wird als Träger genannt. Der Träger ist mit einer isolierenden Schicht bedeckt. Auf der isolierenden Schicht sind Leiterbahnen als Stromzu- und Stromableitungen und dazwischen in Reihenschaltungen Beleuchtungselemente und Vorwiderstandsflächen angeordnet.

Aufgabe vorliegender Erfindung ist es, den Anwendungsbereich von flächigen Beleuchtungseinrichtungen zu erweitern und neue Beleuchtungseinrichtungen mit erweiterten Einsatzmöglichkeiten vorzuschlagen.

Erfindungsgemäss wird dies dadurch erreicht, dass die Licht emittierenden Beleuchtungselemente eine Abfolge gleicher Einheiten auf einer fortlaufenden Trägerbahn, auf der elektrisch isolierenden Schicht des Trägers angeordnet, sind und die elektrisch leitende Schicht des Trägers die Stromableitung darstellt.

Als Licht emittierende Beleuchtungselemente sind beispielsweise Dioden, wie sog. LEDs (light emitting diodes).

Träger sind beispielsweise Folien mehrschichtigen Aufbaues. Ein folienförmiger Aufbau kann, einander anliegend, eine elektrisch leitende Schicht, und auf einer Seite der elektrisch leitenden Schicht, eine elektrisch isolierende Schicht, enthalten.

Die elektrisch leitende Schicht kann beispielsweise eine Metallschicht oder eine metallische Schicht sein. Die Metallschicht kann eine Metallfolie, wie beispielsweise eine Gold-. Silber-, Eisen-, Stahl-, Kupfer-, Zinn- oder Aluminiumfolie sein. Die Metallfolien können auch aus Legierungen enthaltend wenigstens eines der genannten Metalle sein. Bevorzugt sind Aluminiumfolien, resp. Folien aus Aluminiumlegierungen. Es ist ebenfalls möglich mehrschichtige Folien aus wenigstens zwei unterschiedlichen Metallen einzusetzen. Typische Dicken der genannten Metallfolien reichen von ca. 3 µm bis 300 µm, wobei für Aluminiumfolien Dicken von 7 µm bis 70 µm besonders geeignet sind. Statt der Metallfolien können auch dickere als die angegebenen 300 µm -Folien oder -Werkstoffe, wie beispielsweise Bänder, Bleche oder Profile eingesetzt werden. Beispielsweise kann dies erforderlich sein, wenn der elektrisch leitenden Schicht zugleich eine tragende Funktion zukommen soll oder Formstabilität erreicht werden soll. Zur Ableitung der durch die Licht emittierenden Beleuchtungselementen erzeugten Wärme kann die Oberfläche der Metallfolien oder -bleche durch Faltungen oder durch Anbringen von Kühlrippen an Profile vergrössert werden. Eine Metallschicht kann auch mittels eines elektrisch leitfähigen metallhaltigen Lackes, der auf ein Substrat, wie ein Kunststoffsubstrat oder Papier etc. aufgetragen ist, erzeugt werden.

Die metallische Schicht kann eine -- insbesondere auf einem Kunststoff, beispielsweise in Folienform, abgeschiedene -- durch ein chemisches oder physikalisches Abscheideverfahren erzeugte metallische Schicht sein. Die Beschichtung kann durch ein chemisches Verfahren, wie Kunststoffgalvanisierung, oder durch Auftragen oder Aufsprühen von Lösungen, wie Kathodenzerstäubung, erfolgen. Beispiele für eine physikalische Abscheidung sind das Sputtern oder Aufdampfen im Vakuum. Ist die Metallschicht aufgesputtert oder in einem Vakuumdünnschichtverfahren abgeschiedene Metallschicht sein, so können die abgeschiedenen oder aufgedampften Metalle z.B. Gold, Silber, Kupfer, Eisen, Nickel, Zinn, Zink, Aluminium etc., Legierungen oder Mischungen davon sein oder die Schichten können diese Metalle enthalten. Aufgesputterte oder aufgedampfte Schichten können beispielsweise eine Dicke von 2 bis 200 nm (Nanometer) aufweisen.

Die isolierende Schicht kann ein Papier, ein beschichtetes Papier, Halbkarton, Karton oder Pappe oder ein Kunststoff sein. Beschichtete Papiere können mit Wachsen, Hot Melt oder Kunststoffen beschichtete Papiere sein. Als Kunststoffe können beispielsweise Polyvinylchlorid, Polyolefine, wie Polyethylen oder Polypropylen, Polycarbonate, Polyamide, Polyester, Polyacrylnitrile, Polystyrole oder deren Co- oder Pfropfpolymere usw. eingesetzt werden. Als isolierende Schicht ist auch Gummi geeignet. Die isolierende Schicht aus Kunststoff liegt vorteilhaft als Folie vor. Die Folien können auch Laminate oder Schichtstoffe aus 2 oder mehreren Kunststoffschichten darstellen und beispielsweise durch Kaschieren oder Extrudieren hergestellt worden sein. Typische Dicken derartiger Folien liegen bei 12 µm bis 200 µm. Die isolierende Schicht kann auch in Dicken über die angegebenen 200 µm eingesetzt werden, beispielsweise als Platte oder Formteil, wenn der isolierenden Schicht zugleich eine tragende Funktion zukommen soll oder Formstabilität erreicht werden soll.

Die elektrisch isolierende Schicht liegt bevorzugt als Kunststofffolie und die elektrisch leitende Schicht bevorzugt als Metallfolie vor. Die beiden Folien können mittels Primer, mittels Primer und Kleber oder mittels Kleber, durch Kaschieren, untereinander verbunden sein. In anderer Weise kann der Kunststoff als Schicht auf die Metallfolie extrusionskaschiert werden. Die Strom zuführenden Teile der Licht emittierenden Beleuchtungselemente werden in der Regel auf die elektrisch isolierende Schicht aufgedruckt, nass chemisch aufgetragen oder aufgedampft oder eine vollflächige Leiterschicht auf der isolierenden Schicht wird soweit entfernt, wie verdampft oder weggeätzt, dass die erforderlichen Leiterbahnen und Leiterbahnabschnitte mit der Wirkung eines Vorwiderstandes zurückbleiben.

Besonders vorteilhaft werden als Trägerfolie hart gewalzte Aluminiumfolien eingesetzt. Die Trägerfolie wird flächig mit einer isolierenden Schicht, beispielsweise mit einer Decklackschicht, als isolierende Schicht, versehen. Auf die Decklackschicht können beispielsweise im Tiefdruckverfahren, ein- oder mehrschichtig mit einer elektrisch leitenden Farbe, vorzugsweise einer Silberleitfarbe, die verschiedenen Leiterbahnen und Anschlusskontaktflächen aufgedruckt werden. Fallweise können mit einer weiteren Leitfarbe, wie eienr silber- und/oder Grafit, vorzugsweise einer Grafitleitfarbe, die Vorwiderstände aufgedruckt werden. Dabei werden in einem Tiefdruckdurchgang die Stromzufuhr und der Stromverteilung in der Fläche der Beleuchtungseinrichtung dienenden Leiterbahnen als auch die Anschlussflächen für die Licht emittierenden Bauelemente in der Silberleitfarbe aufgedruckt. Vorteilhafter Weise werden die beispielsweise aus Grafitleitfarbe bestehenden Widerstandsflächen der Vorwiderstände, die durch vorzugsweise aus Silber bestehende Ein- und Ausleitungen gespeist werden, durch das Tiefdruckverfahren aufgedruckt. Die erforderliche Verlustleistung der Vorwiderstände wird durch die relativ grossflächige Ausgestaltung der aufgedruckten Widerstandsflächen erreicht. Die Licht emittierenden Beleuchtungselemente werden beispielsweise mit einem silberhaltigen Leitkleber an den entsprechenden Anschlusskontaktflächen verklebt, oder an diesen verlötet. Silberhaltige Leitkleber besitzen einen sehr kleinen Wärmeleitkoeffizienten, so dass eine gute Wärmeableitung aus den Licht emittierenden Beleuchtungselementen bis hin zur metallischen Trägerfolie erfolgt.

Die einzelnen Beleuchtungselemente, bzw. Licht emittierenden Dioden können die während des Betriebes erzeugte Wärme in den Träger, z.B. die als Träger dienende metallische Trägerfolie, ableiten. Die einzelnen Beleuchtungselemente können eine Leistungsaufnahme von beispielsweise 0,1 Watt bis 5 Watt aufweisen. Nicht nur an schwache LEDs, mit z.B. 0,1 bis 0,5 Watt, sondern auch so genannte Power-LEDs mit z.B. 2 bis 5 Watt, bevorzugt 3 Watt, können eingesetzt werden. Je nach ihrer Anzahl können die LEDs mit einer Betriebsspannung von z. B. 20 V betrieben werden. Damit liegt die Betriebsspannung im Bereich von Kleinspannungen gemäss den VDE-Normen. Der Isolationsaufwand wird daher vorteilhafter Weise gering gehalten. Die LEDs können auch Halbleiterchips ohne Gehäuse sein, die direkt aufgeklebt werden und mit Draht gebondet, resp. angeschlossen, werden.

Die Licht emittierenden Beleuchtungselemente sind eine Abfolge von Einheiten, vorteilhaft eine Abfolge gleicher Einheiten, die sich in der Fläche in eine oder beide Richtungen erstrecken. Die Licht emittierenden Beleuchtungselemente lassen sich beispielsweise kontinuierlich in Form einer Trägerbahn herstellen, wobei die Breite und Länge der Trägerbahn an sich unkritisch ist und sich nach den Ausgangsmaterialien und den maschinellen Gegebenheiten richtet. Typisch sind Licht emittierenden Beleuchtungselemente, bahnförmig angeordnet, mit beispielsweise 1 bis 100 Einheiten über die Breite der Trägerbahn und 1 bis zu einer beliebigen Zahl an Einheiten, die sich über die Länge der Trägerbahn erstrecken. Zweckmässig sind flächige Beleuchtungseinrichtungen deren fortlaufende Trägerbahn wenigstens eine Einheit breit und wenigstens zwei Einheiten lang ist. Bevorzugt sind 2 bis 50 Einheiten in Trägerbahnbreite. In Trägerbahnlänge sind 2 bis 200 Einheiten bevorzugt.

In einer besonders günstigen Ausführungsform liegen die Einheiten der flächigen Beleuchtungseinrichtung in Längsrichtung und/oder in Querrichtung jeweils in einer Flucht, resp. im Rapport. Die Einheiten können auch individuelle Aussenbegrenzungen aufweisen. Eine spätere Aufteilung einer flächigen Beleuchtungseinheit in ausgewählt angeordnete Gruppierungen von Einheiten gestaltet sich entsprechend aufwendiger.

In der flächigen Beleuchtungseinrichtung ist vorteilhaft jede Einheit von einer endlosen Leiterbahn umringt. Die umringende Leiterbahn stellt Teil der Stromversorgung, resp. Stromzufuhr, innerhalb der flächigen Beleuchtungseinrichtung dar. Von der umringenden Leiterbahn führt eine Strom führende Bahn zur LED. Diese Strom führende Bahn weist in ihrer ganzen oder in einer teilweisen Länge ein Widerstand dar und formt damit den Vorwiderstand. Das Mass des Widerstandes der Strom führenden Bahn wird durch die Querschnittsfläche und/oder die Leitfähigkeit der Bahn oder eines Abschnittes der Bahn erreicht.

Jede Einheit kann mit der oder den benachbarten Einheiten über Leiterbahnen Strom führend miteinander verbunden sein.

An der erfindungsgemässen flächigen Beleuchtungseinrichtung kann jede Einheit des Licht emittierenden Beleuchtungselementes, durch eine Ausnehmung in der isolierenden Schicht hindurch, elektrisch leitend mit dem Träger verbunden sein. Der Träger stellt die Stromableitung dar. Die Ausnehmung durch die isolierende Schicht hindurch, kann durch beispielsweise durch Durchstechen mittels eines nadelförmigen Instrumentes, durch mechanischen Abtrag, wie Ausstanzen oder Bohren, durch Ätzen oder Verdampfen mittels Elektronenstrahl oder Laserstrahl erfolgen. Der stromabführende Leiter vom Licht emittierenden Beleuchtungselement zur Trägerfolie kann ebenfalls eine Leiterbahn, wie vorbeschrieben, sein. Fallweise kann es sich als notwendig erweisen, den Kontakt zwischen der Leiterbahn und der Trägerfolie, durch die Ausnehmung in der isolierenden Schicht hindurch, zu verbessern oder überhaupt einzurichten. Dies kann durch Verbindung der Leiterbahn und der Trägerfolie mittels eines leitfähigen Lackes oder durch einen Lötpunkt, welche im wesentlichen die Ausnehmung durchdringen, erfolgen.

Vorteilhaft liegen die Einheiten in Längsrichtung und/oder in Querrichtung jeweils in einer Flucht. Zwischen den Einheiten sind vorteilhaft Schneidezonen angeordnet. Die Schneidezonen sind zwischen den einzelnen Einheiten angeordnet und bilden somit Platz für die Schnittlinien zum späteren Vereinzeln von Einheiten oder Gruppen von Einheiten. Da vorteilhaft jede Einheit mit der oder den benachbarten Einheiten über Leiterbahnen Strom führend miteinander verbunden ist, können beliebige Einheiten abgeschnitten werden, die unabhängig voneinander funktionieren.

Zwischen jeder Einheit kann innerhalb der Schneidezone ein Trennschnitt angelegt werden und wenigstens eine Einheit aus der Beleuchtungseinrichtung ausgenommen oder von der Beleuchtungseinrichtung randständig abgetrennt werden. Das Abtrennen oder Ausnehmen von Einheiten oder Gruppen von Einheiten oder Gruppen von Einheiten in einer musterhaften Anordnung kann mechanisch durch Trennverfahren, wie Stanzen oder mittels Messer oder Schere erfolgen. Trennverfahren, wie Laserschneidverfahren, Trennen mittels Wasserstrahl und dergl. können ebenfalls angewendet werden. Die genannten Trennverfahren könne auch computerunterstützt gefahren werden. Dies ermöglicht, mit der Trennvorrichtung komplexe Muster von der flächigen Beleuchtungseinrichtung abzutrennen oder auszunehmen oder nicht linearen oder gekurvten Schnittlinien zu folgen.

Zum Betrieb der erfindungsgemässen flächigen Beleuchtungseinrichtung kann wenigstens eine Leiterbahn, beispielsweise eine oder mehrere der endlosen Leiterbahnen oder eine oder mehrere der die Einheiten verbindenden Leiterbahnen über eine Stromzuführung an den Strom angeschlossen werden. Ebenfalls wird über eine Stromabführung die elektrisch leitende Schicht an den Stromkreis angeschlossen. Jede Diode oder LED wird nun über die endlosen Leiterbahnen und die Strom führende Bahn, resp. Vorwiderstand, mit Strom versorgt und über die Stromabführung zur elektrisch leitenden Schicht wird der Stromkreis geschlossen.

Bei einer weiteren bevorzugten Ausgestaltung der Erfindung wird die flexible metallische Trägerfolie durch ein stabiles Verbundteil verstärkt, so dass selbsttragende Leuchtpaneele hergestellt werden können. Hierbei wird der Träger beispielsweise auf Platten aus einem kompakten, geschäumten oder wabenförmigen Material, wie eine Kunststoffpaneele, eine Holzpaneele, ein Kunststoffschaum oder eine Wabenplatte, durch Kleben, festgelegt, d.h. zu einem Verbundteil verarbeitet. Die Seite mit den Licht emittierenden Beleuchtungselementen, kann z.B. mit einem optisch transparenten, eine die Färbung des Lichtes verändernde oder einem eine diffuse Lichtverteilung bewirkenden opaken Kunststoffschutzschicht abgedeckt werden. Durch die Kunststoffschicht werden die Licht emittierenden Beleuchtungselemente, Leiterbahnen und Widerstände zudem in vorteilhafter Weise gegen mechanische und elektrische Einflüsse geschützt. Es können auch möglich, auf der einen Seite der flächigen Beleuchtungseinrichtung das stabile Verbundteil und auf der Seite der Licht emittierenden Beleuchtungselemente die Kunststoffschutzschicht anzuordnen. Es entsteht ein stabiles aufteilbares Sandwichelement mit Wärme ableitender und/oder formstabiler Rückseite und Licht abgebender Vorderseite. Zur Stromversorgung der LEDs kann beispielsweise eine Kontaktklammer zur Stromzuführung an wenigstens einer Stelle an eine der Leiterbahnen angeschlossen werden und anderseits kann die Stromabführung über eine Kontaktklammer, welche die elektrisch leitende Schicht berührt, erfolgen. Statt einer oder mehrerer Klammern können die Stromführungen auch an die Leiterbahnen oder elektrisch leitende Schicht angelötet oder anderweitig Strom führend, festgelegt werden.

Die Figuren zeigen beispielhaft Ausführungsformen vorliegender Erfindung.

Figur 1 stellt eine Draufsicht auf eine flächige Beleuchtungseinrichtung dar.

Figur 2 zeigt einen Schnitt durch einen Teil einer Einheit.

Figur 3 ist ein Ersatzschaltbild vorliegender Beleuchtungseinrichtung.

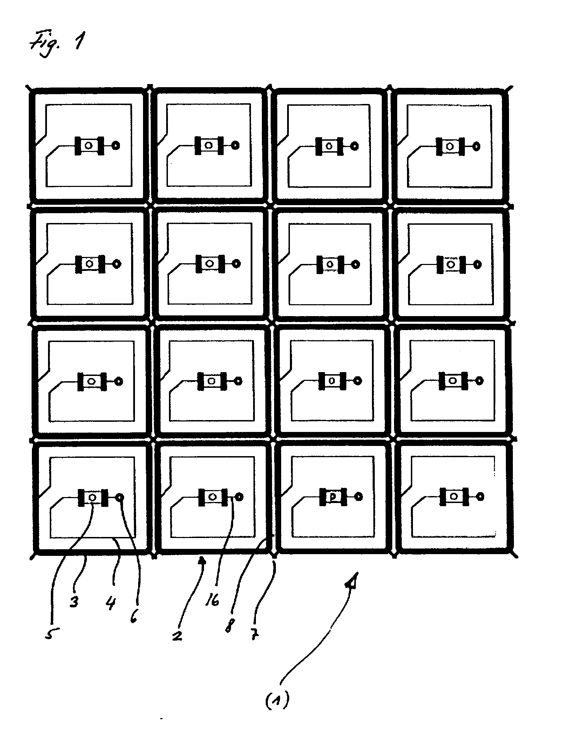

Figur 1 zeigt eine Draufsicht auf einen Ausschnitt (1) der flächigen Beleuchtungseinrichtung. Die Einheiten (2) sind in Längs- und Querrichtung angeordnet. Beispielhaft sind je 4 Einheiten (2) in Längs-, wie in Querrichtung, dargestellt. Die Anzahl der nebeneinander, resp. hintereinander, liegenden Einheiten (2) ist unkritisch und richtet sich nach der Breite und der Länge der Trägerbahn und den maschinellen Gegebenheiten, d.h. die Einheiten sind endlos im Rapport auf dem Träger aufgebracht. Der Träger enthält in seinem Aufbau eine isolierende Schicht und eine elektrisch leitende Schicht. Beispielhaft sind die Einheiten (2) im wesentlichen quadratisch dargestellt. Es ist auch möglich, die Einheiten (2) polygonal, wie rechteckig, dreieckig usw., rund, oval, etc. darzustellen. Jede Einheit (2) ist von einer endlosen Leiterbahn (3) umringt. Von der Leiterbahn (3) zweigt in jeder Einheit (2) eine Strom führende Bahn (4). Die Strom führende Bahn (4) stellt in ihrer ganzen Länge oder über einen Teil ihrer Länge den Vorwiderstand dar. Die den Vorwiderstand darstellende Strom führende Bahn (4) oder eine den Vorwiderstand darstellende Teilstrecke davon, kann z.B. aus Silber oder Graphit oder Gemischen davon sein oder Silber und/oder Graphit enthalten. Es handelt sich dabei um beispielsweise Lacke, Drucklacke oder aufgedampfte oder nasschemisch abgeschiedene Bahnen. Die Strom führende Bahn (4) ist an die Licht emittierende Diode (LED) (5) angeschlossen. Die Strom führenden Bahnen (4) sind auf der isolierenden Schicht angeordnet. Von der Diode (5) führt ein Leiter weiter, wobei der Leiter zu einer Ausnehmung (6) in der isolierenden Schicht führt, dort die isolierende Schicht durchstösst und mit der elektrisch leitenden Schicht verbunden ist. Die Einheiten sind gegenseitig durch Versorgungsleiter (7) verbunden. Die Versorgungsleiter sind liegen zwischen den Ecken der Leiterbahn (3). Statt der sich kreuzenden Versorgungsleiter (7) kann auch eine zwischen den jeweils 4, resp. randständig der Trägerbahn 2, Ecken eine flächenförmiger, wie klecksartiger Versorgungsleiter vorgesehen sein, der alle vier, resp. 2, Ecken leitend miteinander verbindet. Zwischen den Seitenrändern der benachbarten Einheiten (3) sind die Schnittlinien (8) erkennbar. Entlang den Schnittlinien (8), kann eine flächige Beleuchtungseinrichtung nach vorliegender Erfindung beliebig zugeschnitten werden. Es ist möglich beliebig viele Einheiten in der Länge und Breite aus einem Band mit der flächigen Beleuchtungseinrichtung (1) abzutrennen. Es ist auch möglich, beliebige Muster aus Einheiten aus der vollen Fläche auszuschneiden oder einzelne oder mehrere Einheiten herauszutrennen. Die zugeschnittenen flächigen Beleuchtungseinrichtungen müssen danach nur noch an die Stromversorgung angeschlossen werden. Ein Ausfall einer Leuchtdiode oder ein Stromunterbruch in einer Leiterbahn führt nur zum Ausfall der jeweils betroffenen Leuchtdiode. Der Stromfluss zu und zwischen den anderen Einheiten ist durch die übrigen Leiterbahnen gewährleistet und entsprechend bleiben die Leuchtdioden der nicht betroffenen Einheiten aktiviert.

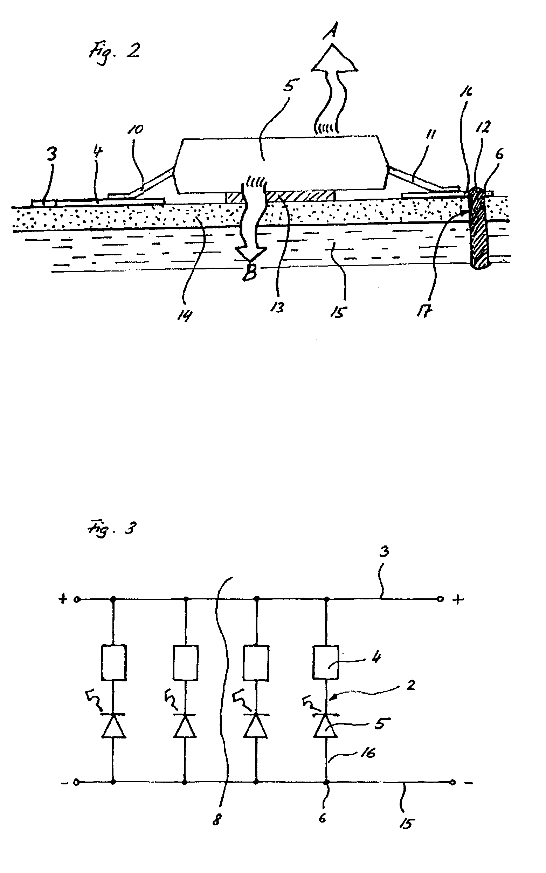

Figur 2 stellt einen Schnitt durch einen Teil einer Einheit (2) dar. Eine Licht emittierende Diode (LED) (5) ist schematisch, das Gehäuse darstellend, gezeigt. Die Diode (5) ist über eine Verbindungsmasse (13) mit der tragenden Struktur, resp. dem Träger, vorliegend dargestellt aus isolierender Schicht (14) und elektrisch leitender Schicht (15), mechanisch und Wärme leitend verbunden. Von der Diode (5) ragen die Anschlussbeinchen (10, 11) ab. Das Strom zuführende Anschlussbeinchen (10) ist mit der Strom führenden Bahn (4) verbunden. Zumindest eine Teilstrecke der Strom führenden Bahn (4) wirkt als Vorwiderstand. Die Strom führende Bahn (4) mündet in die Leiterbahn (3). Das Strom abführende Anschlussbeinchen (11) ist mit dem Strom abführenden Leiter (16) verbunden. Der Strom abführende Leiter (16) führt zu einer Ausnehmung (6). Die Ausnehmung (6) in Leiter (16) setzt sich als Ausnehmung (17) durch die isolierende Schicht (14) fort, die isolierende Schicht (14) und die elektrisch leitende Schicht vollständig durchdringend fort. Eine leitende Masse (12), wie z.B. ein elektrisch leitender Lack oder Lot, stellt den elektrischen Kontakt zwischen der elektrisch leitenden Schicht (15) und dem Strom abführenden Leiter (16) her. Pfeil A deutet die Lichtausstrahlung der Diode (5) an. Pfeil B zeigt den Abfluss der in der Diode (5) erzeugten Wärme in den Träger.

Figur 3 stellt ein Ersatzschaltbild einer erfindungsgemässen Beleuchtungseinrichtung dar. Von der Leiterbahn (3) zweigt zu jeder der vier identischen Einheiten (2) eine Strom führende Bahn. Die Strom führende Bahn führt zu einem Vorwiderstand (4), verlässt den Vorwiderstand (4) und ist an die Licht emittierende Diode (LED) (5) angeschlossen. Die Lichtemission ist durch einen Pfeil symbolisiert. Der Strom abführende Leiter (16) endet an einem Kontakt zur leitenden Schicht (15). Der Kontakt kann beispielsweise eine Ausnehmung (6) in der hier nicht dargestellten isolierenden Schicht sein. Über eine Kontaktmasse, wie einen durch die Ausnehmung hindurch reichenden leitenden Lack oder ein Lot, kann der Kontakt zwischen dem Strom abführenden Leiter (16) und der leitenden Schicht (15) geschaffen werden. Die Schnittlinie (8) deutet an, dass an jener Stelle - wie auch beliebig zwischen zwei Einheiten (2) - die Einheiten (2) voneinander getrennt werden können.

## Patentansprüche

1. Flächige Beleuchtungseinrichtung mit auf einem Träger, enthaltend eine elektrisch isolierende Schicht und eine elektrisch leitende Schicht, angeordneten Licht emittierenden Beleuchtungselementen, die zur Stromversorgung mit Stromzuleitungen in Form wenigstens einer Leiterbahn verbunden sind,
**dadurch gekennzeichnet, dass**
die Licht emittierenden Beleuchtungselemente eine Abfolge gleicher Einheiten auf einer fortlaufenden Trägerbahn, auf der elektrisch isolierenden Schicht des Trägers angeordnet, sind und die elektrisch leitende Schicht des Trägers die Stromableitung darstellt.

2. Flächige Beleuchtungseinrichtung gemäss Anspruch 1, **dadurch gekennzeichnet, dass** die fortlaufende Trägerbahn wenigstens eine Einheit breit und wenigstens zwei Einheiten lang ist.

3. Flächige Beleuchtungseinrichtung gemäss Ansprüchen 1 und 2, **dadurch gekennzeichnet, dass**, die Einheiten in Längsrichtung und/oder in Querrichtung jeweils in einer Flucht liegen.

4. Flächige Beleuchtungseinrichtung gemäss Ansprüchen 1 bis 3, **dadurch gekennzeichnet, dass**, jede Einheit von einer endlosen Leiterbahn umringt ist.

5. Flächige Beleuchtungseinrichtung gemäss Ansprüchen 1 bis 4, **dadurch gekennzeichnet, dass** jede Einheit mit der oder den benachbarten Einheiten über Leiterbahnen Strom führend verbunden ist.

6. Flächige Beleuchtungseinrichtung gemäss Ansprüchen 1 bis 5, **dadurch gekennzeichnet, dass**, in jeder Einheit das Licht emittierende Beleuchtungselemente durch eine Ausnehmung in der elektrisch isolierenden Schicht hindurch elektrisch leitend mit der elektrisch leitenden Schicht des Trägers verbunden ist.

7. Flächige Beleuchtungseinrichtung gemäss Ansprüchen 1 bis 6, **dadurch gekennzeichnet, dass** die Einheiten in Längsrichtung und/oder in Querrichtung jeweils in einer Flucht liegen und zwischen den Einheiten Schneidezonen angeordnet sind.
